# EUROPEAN PATENT SPECIFICATION

(11) **EP 0 970 476 B1**
(45) Date of publication and mention of the grant of the patent: **29.01.2003**
(21) Application number: 98910876.6
(22) Date of filing: 18.03.1998
(51) Int. Cl.: G11C 21/00, G02F 3/00

(54) **AN OPTICAL MEMORY**
OPTISCHER SPEICHER
MEMOIRE OPTIQUE

(30) Priority: 27.03.1997 GB 9706370; 01.08.1997 US 904836
(43) Date of publication of application: 12.01.2000
(73) Proprietor: BRITISH TELECOMMUNICATIONS public limited company, London EC1A 7AJ (GB)
(72) Inventor: POUSTIE, Alistair, James, Ipswich IP4 5LL (GB); BLOW, Keith, James, Woodbridge IP12 4LE (GB); MANNING, Robert, John, Ipswich IP1 6RB (GB)
(74) Representative: Roberts, Simon Christopher
(86) International application number: GB9800821
(87) International publication number: WO98044512

(56) References cited:
- EP-A- 0 237 184
- EP-A- 0 320 305
- EP-A- 0 375 346
- EP-A- 0 543 314
- EP-A- 0 762 677
- WO-A-92/09916
- WO-A-93/08574
- US-A- 5 311 347
- MANNING ET AL: "all optical clock division using a semiconductor optical amplifier loop mirror with feedback" ELECTRONICS LETTERS, vol. 32, no. 16, August 1996, pages 1504-1505, XP000624495 STEVENAGE GB

## Description

The invention relates to an optical memory.

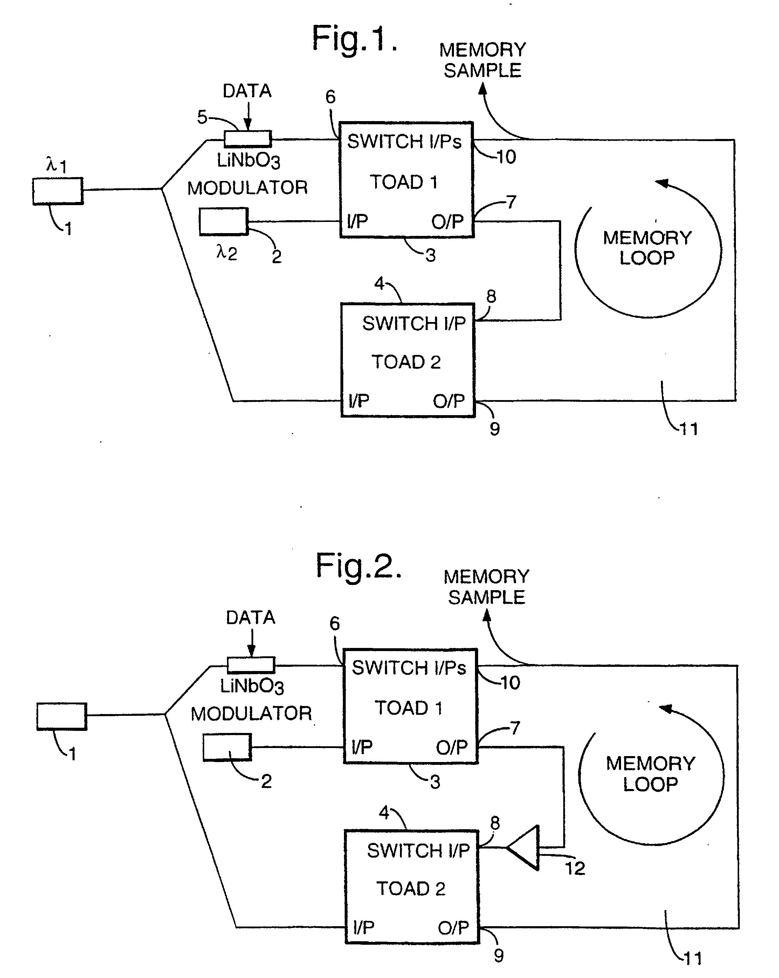

The function of "memory" is one of the key building blocks to implement advanced information processing in future ultrahigh-speed photonic networks. For example, memory allows 100Gbit/s optical packets to be buffered and queued for subsequent processing of the data. Memory is also an intrinsic function for serial optical computing systems. Several types of serial optical memory have been demonstrated previously using recirculating optical fibre loops. These memory designs are either pulse-preserving, where the same optical pulses propagate on each circulation of the storage loop, or regenerative where the pulses are replaced after some number of memory circulations. For pulse preservation memories, the long term stability of the data pattern depends on being able to retime and reshape the optical pulses within the memory loop, since it acts like a long transmission line and the pulses are degraded by propagation effects. These effects are reduced by regenerative architectures which therefore offer superior stability. An all-optical regenerative memory is described in a paper entitled "All-optical regenerative memory", A. J. Poustie, K. J. Blow and R. J. Manning, Nonlinear Guided Waves and their Applications, Vol. 15, 1996 OSA Technical Digest Series, which has now been developed so that an optical pulse binary data pattern can be stored for several hours. This highly stable operation is achieved by full all-optical regeneration of the data pattern after each circulation of an optical fibre delay line. This all-optical memory design, shown in Figure 1, is a combination of two nonlinear optical switching elements and an optical fibre storage loop.

According to the present invention as defined by claim 1, there is provided a regenerative optical memory having a transfer function arranged so that only optical data having a pulse amplitude above a predetermined threshold is stored and the amplitude of optical data stored is substantially equalised to at least one predetermined level after a number of circulations within the optical memory.

In the present invention, a regenerative optical memory is arranged to provide a transfer function which achieves amplitude equalisation for optical data stored by the memory. This has the effect of removing noise. Furthermore, any pulse amplitude modulation in the original input data is also removed. Equalisation may be to a number of predetermined levels determined by the transfer function of the memory. Only data which has a pulse amplitude above a storage threshold level determined by the transfer function of the memory is stored. Preferably, the regenerative memory includes means to vary the storage threshold level.

Preferably, the regenerative memory comprises means for changing the energy of optical data pulses. More preferably, the regenerative memory comprises an optical amplifier, the gain of which is selected for stable storage of data. If the amplifier gain is too low then data rapidly decays as it recirculates the memory. If the amplifier gain is too high then random data may be created in the memory by the amplification of signals having a finite energy. Suitable optical amplifiers include semiconductor optical amplifiers and erbium doped optical amplifiers.

Preferably, the regenerative memory comprises a non-linear switching element. More preferably, the regenerative memory comprises two concatenated non-linear switching elements coupled together by an optical storage element. Preferably, the optical storage element is a length of optical fibre. Alternatively, the optical storage element may be an optical waveguide, suitable examples of which include planar silica waveguides and semiconductor waveguides. Suitable non-linear optical switching elements are semiconductor laser amplifiers in a loop mirror (SLALOMs). These are interferometric non-linear switches with an optical amplifier as the non-linear element. Most preferably, the non-linear switching elements are terahertz optical asymmetric demultiplexers (TOADs), each of which is driven by an optical source. Suitable optical sources are distributed feedback semiconductor lasers.

Preferably, the optical memory comprises an optical source for supplying switching pulses to an input of the optical switching element.

Preferably, the optical switching element is an interferometric non-linear switch with an optical amplifier as the non-linear element. More preferably, the optical switching element is a terahertz optical asymmetric demultiplexer (TOAD), which is responsive to switching pulses from the optical source to allow data to be switched out of the optical loop.

Preferably, the optical switching element includes an output for reading out data switched out of the optical loop.

There are several applications for optical memories according to the invention. Such a memory may be included in, for example, a computer, an optical repeater, or a communication network.

Examples of the present invention will now be described and contrasted with a known memory with reference to the accompanying drawings, in which:
Figure 1 shows an existing all-optical regenerative memory;
Figure 2 shows a first example of an all-optical regenerative memory in accordance with the present invention;
Figure 3 shows the evolvement of a non-linear switching characteristic from a cosine squared response to a square window;
Figure 4 shows how the square window response shown in Figure 3 varies as a transfer function of a non-linear optical switching element within the memory is varied;
Figures 5(a) to 5(e) shows oscilloscope traces for a number of data patterns;
Figure 6 shows a second example of an all-optical regenerative memory in accordance with the present invention;
Figures 7 to 9 show experimental results from writing and reading data from the memory of Figure 6 with different "read" patterns;
Figure 10 shows an example of a communication network; and,
Figure 11 shows a modified version of the regenerative memory of Figure 6.

For the purpose of describing the present invention a known all-optical regenerative memory is-shown in Figure 1. Two jitter-suppressed gain-switched distributed feedback (DFB) semiconductor lasers 1 and 2 at wavelengths 1.551µm (λ₁) and 1.533µm (λ₂), respectively, are provided as the optical pulse sources. The pulse repetition rate is ≈1GHz and each source gives ≈10ps pulses after linear chirp compensation in a length of normally dispersive optical fibre. Two nonlinear optical switching elements 3 and 4 are provided each comprising a 50:50 fused fibre coupler, two wavelength division multiplexed (WDM) couplers to introduce and reject the switching pulses, a fibre polarisation controller to bias the loop mirror and a semiconductor optical amplifier offset from the loop centre to give a switching window of ≈80ps. Optical switching elements of this type, known as terahertz optical asymmetric demultiplexers (TOADS) , are described in a paper entitled "Asymmetric optical loop mirror: analysis of an all-optical switch", Applied Optics, vol. 33, No. 29, 1994. The pulse train at λ₂ is used as the input to the optical switching element 3 which is biased to total reflection in the absence of the switching pulses. The pulse train at λ₁ is split in two; one half is used as the input to the optical switching element 4 which is also biased to total reflection, the other half is modulated with a LiNbO₃ amplitude modulator 5 to generate the data pattern to be stored and is fed, only once, into a switching port 6 of the optical switching element 3. To complete the memory circuit, the transmitted output 7 of the optical switching element 3 is connected to the switching input 8 for the optical switching element 4 and the transmitted output 9 of the optical switching element 4 is connected to a second switching port 10 in the optical switching element 3 by an optical fibre storage loop 11. Thus, the optical switching element 3 switches the data pattern from λ₁ to λ₂ and the copied data is fed into the memory loop 11. The optical switching element 4 only wavelength converts the data back to λ₁ so that it can subsequently switch the optical switching element 3 again. The contents-of the memory can be monitored by a 10% tap (not shown) within the fibre loop 11. Both short (pattern length <<τ) and long (pattern length ≈ τ) data sequences can successfully be stored for several hours with this arrangement. This corresponds to greater than 10 billion circulations around the memory circuit and an effective bit error rate ratio of <10⁻¹³.

Figure 2 shows an example of an all-optical regenerative memory of the present invention which provides amplitude equalisation such that any pulse amplitude modulation in the original input data is removed. The architecture can discriminate between input pulses of differing amplitudes and so self select which pulses to store. As with the architecture in Figure 1, the memory architecture in Figure 2 is a combination of two concatenated nonlinear optical switching elements 3 and 4. Stable storage for several hours is obtained by full all-optical regeneration of the optical pulse data pattern after each circulation of an optical fibre storage loop 11. These semiconductor optical amplifier based nonlinear optical switches have some advantages over all-fibre switching devices in that they require a very low switching energy (typically ≈ 1 pJ per pulse) and can be relatively compact to reduce latency in the optical processing system. In addition to Figure 1, however, an erbium amplifier 12 is inserted in the loop connecting the output 7 of the switching element 3 to the switching input 8 of the switching element 4.

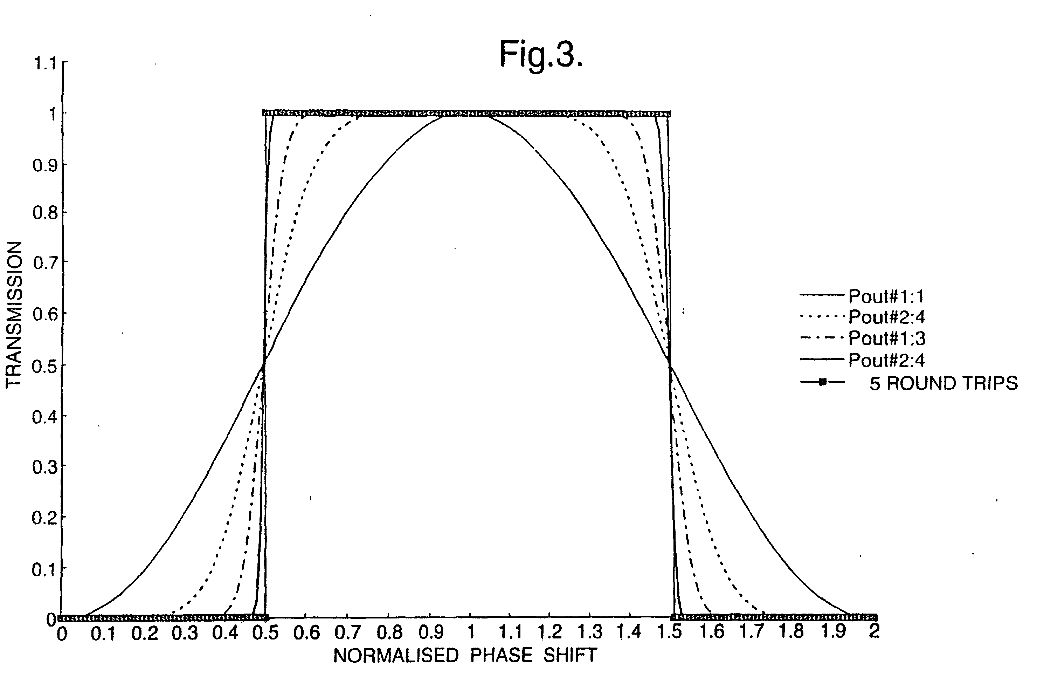

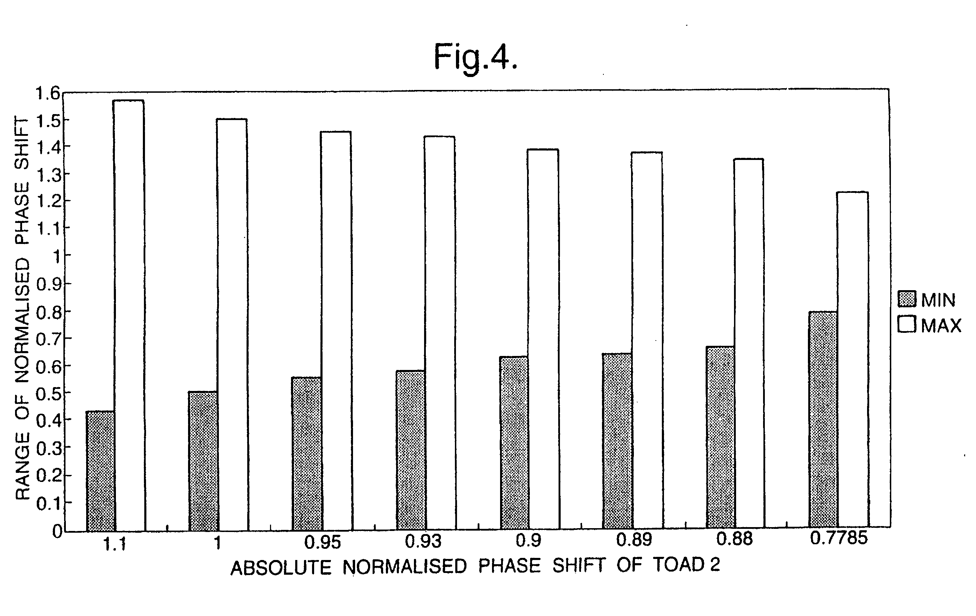

The additional signal processing functions provided by this architecture are achieved by the use of a variable threshold level, which is selected to provide stable storage. The main feature of the memory architecture which allows these additional signal processing functions is the sinusoidal transmission function of each of the nonlinear switching elements. For one round trip of the memory, there is an effective concatenation of nonlinear response functions and each time the data is regenerated, this transfer function is re-applied. Under this condition, the nonlinear switching characteristic rapidly evolves from a cosine squared response to a square window, as shown in Figure 3. The graphs in Figure 3 are normalised so that an energy of 1 unit gives a phase shift of pi radians (and therefore 100% switching in a TOAD) and pi radians is shown normalised to unity. The very square response is shown after 5 round trips and gives the steady state transmission of the memory. Figure 4 shows the ranges of this eventual square window as the overall transfer of the optical switching element 4 is varied (keeping the transfer function of the optical switching element 3 fixed). Below an absolute transfer value of 0.7785, the memory does not sustain a window and the pulses are lost. As the value increases, the window gets wider and the threshold for storage is reduced. The flat top of the concatenated response creates the amplitude restoration function, as any input pulses with an initial energy in the range >pi/2 to <3pi/2 are transformed to have equal energies. Similarly, any initial pulses with energies <pi/2 or >3pi/2 are quickly suppressed and the threshold energy for storage is at pi/2.

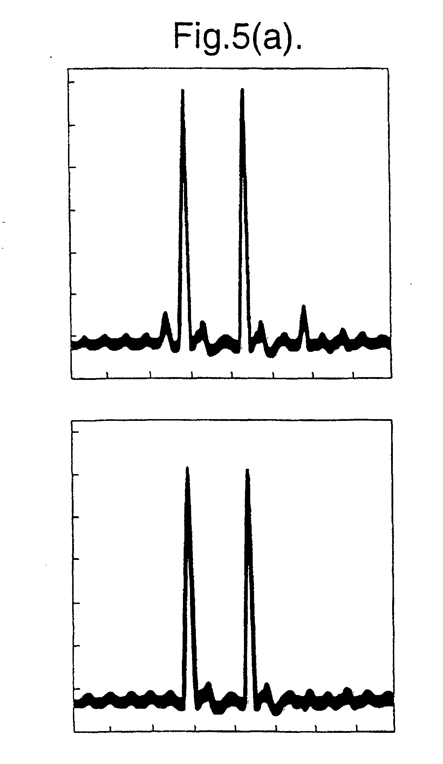

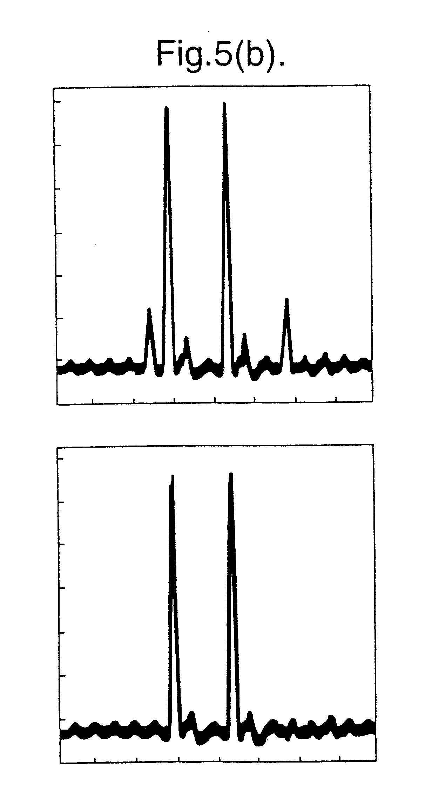

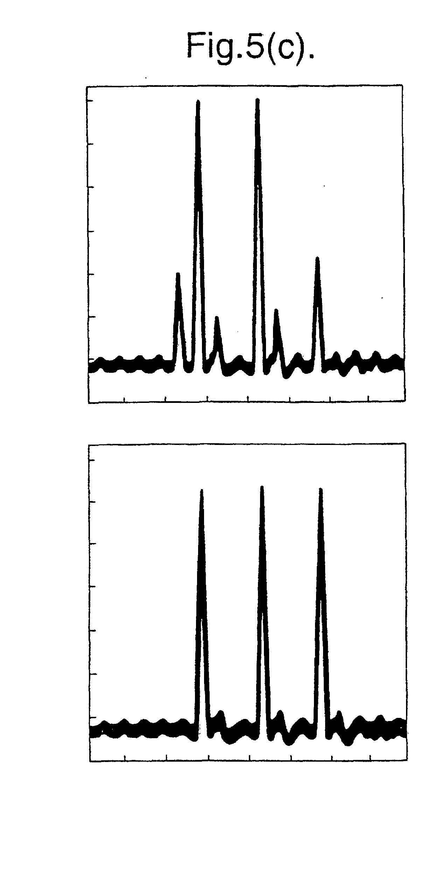

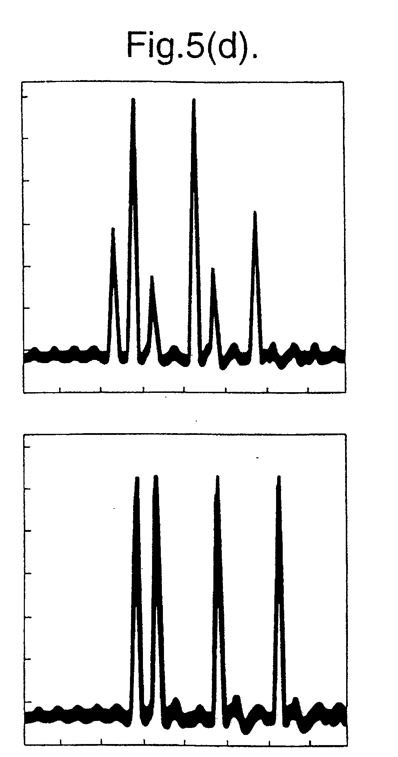

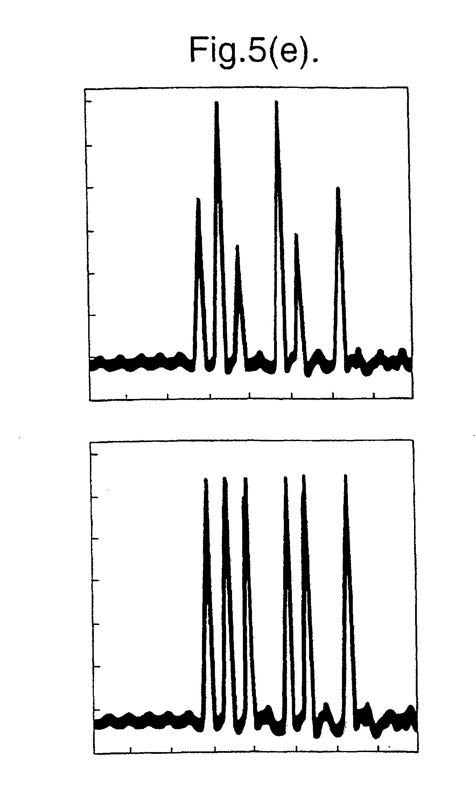

In this experimental system, the data generator (not shown) used to input the pulse data pattern once into the memory has two independent channels which are combined to drive the LiNbo₃ amplitude modulator 5. One channel (binary sequence 01001000) is held at a constant output and the second channel (binary sequence 10100101) is changed in amplitude to create a variable amplitude input pulse sequence to the memory. Since the lifetime of the erbium amplifier 12 provided in this memory is much longer than the pulse repetition rate then all the pulses are equally amplified and retain their relative amplitudes. The experimental results are shown in Figures 5(a) to 5(e). The upper oscilloscope traces in each Figure show the original input pulse data patterns and the lower traces show the data patterns stored in the memory after the initial pattern has been input once. The Figures show sequentially how only the pulse amplitudes above the threshold level are stored and amplitude equalised. The dependence of the threshold level position was measured by fixing the input data pattern as in Figure 5(c) and the threshold level varied by adjusting the gain of one of the erbium amplifier 12 between the optical switching elements 3 and 4 to modify the overall transfer function. As the threshold level is progressively lowered, the stored pattern follows the sequence shown in Figure 5(c) to Figure 5(e) so that all pulses are stored as opposed to only three being above the original threshold level.

It is possible to adjust the transfer function of the regenerative memory by adjusting the gain of the erbium amplifier to give a phase shift of greater than pi radians for some pulses so that instead of a square window characteristic, the concatenated transfer function is a castellated window. This allows amplitude equalization at a number of different levels, dependent on the phase shift of each pulse.

Although a single erbium amplifier 12 is shown in Figure 2, further amplifiers may be provided as appropriate.

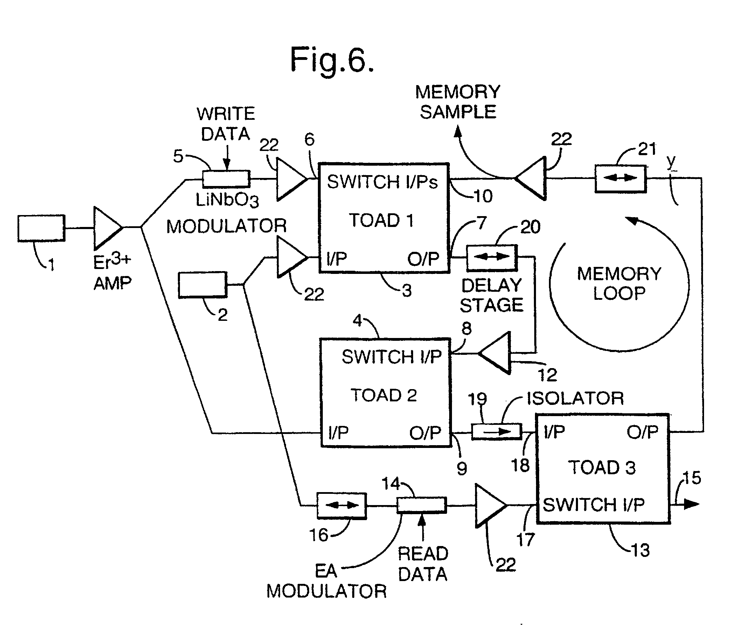

The regenerative optical memory shown in Figure 6 is similar to that of Figure 2 but includes a third optical switching element 13 (TOAD3) which facilitates selective modification of a data pattern stored in the memory. A pulse train at λ₂ from the DFB semiconductor laser 2 is fed via a delay stage 16 to an electro absorption modulator 14 where it is modulated with read data and supplied to a switching input 17 of the third optical switching element 13. A data input 18 of the element 13 is connected via an isolator 19 to the output 9 of the switching element 4. In the absence of a switching pulse at the input 17, the pattern of data continues to circulate within the optical memory via the switching element 13. When a switching pulse is applied to the switching input of the optical switching element 13, if a data pulse is present at the input to the optical switching element 13 at the same instant, the data pulse is switched out of the memory loop 11. The switched data pulse can be read out at the output 15 of the optical switching element 13. In this manner, the optical switching element 13 performs an AND function, selectively removing data from the data pattern stored in the memory. With regard to the data pattern circulating within the optical memory, this results in selective removal of pulses corresponding to logical "1"s.

In this experimental configuration, the pulses which are read are blocked by the isolator 19 or the input to the element 13, but they could be directly accessed by using a fibre-optic circulator. The switching elements 3,4 both contain semiconductor optical amplifiers (SOAs) which have band-edges around 1560nm. This has the advantage of maximising the phase change to gain change ratio at the operating wavelengths and reducing the degree of amplitude modulation for the pulses in the elements.

The adjustable delay line 16 and further adjustable delay lines 20,21 (e.g. Santec ODC-300) are used to attain bit-level synchronisation.

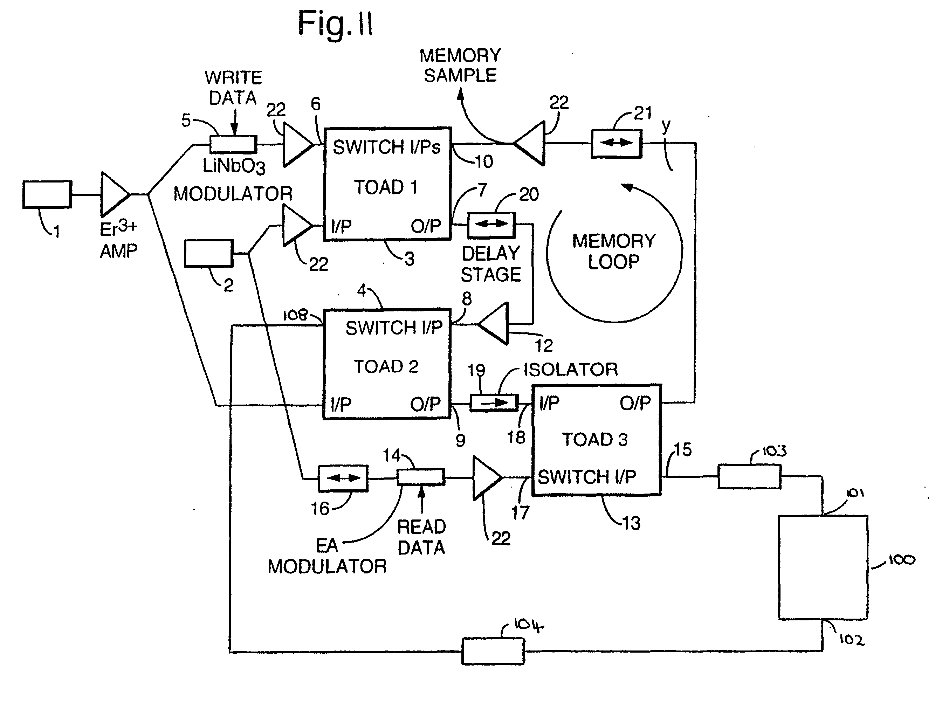

A modified version of the apparatus of Figure 6 is shown in Figure 11, in which the output 15 of the optical switching element 13 is connected to an input 101 of a subsequent regenerative memory. This subsequent regenerative memory 100 may be of any suitable form, although preferably, it will be a regenerative memory according to the invention, for example as shown in Figure 2. If this is the case, the input 101 is formed by applying received optical pulses directly to the switch input 6 of the switching element 3, instead of having the modulator 5. With the regenerative memory 100 present, upon the application of a switching pulse to the switching input 17, any data pulse present at the input 18 to the optical switching element 13 will be read out of the memory loop and into the regenerative memory 100 via the output 15. Thus, by applying a continuous sequence of switching pulses to the switching input 17, a stream of data pulses can be read out from the memory loop and stored in the regenerative memory 100.

These pulses can be temporarily stored and then reinserted into the memory loop by connecting an output 102 of the regenerative memory 100 to a second switching input 108 of the switching element 4.

Obviously, in order for a sequence of data to be successfully written into the memory loop, it is preferable for there to be no data pulses present in the loop at the point at which the data is to be written in, i.e. at the switching input 8. This can be achieved by either clearing a section of the memory using the switching element 13, as described above. Alternatively the subsequent data pulses can be simply rewritten over the data pulses presently in the memory. In this way, for example, it is possible to swap over the most significant bits of the data to be written in with the least significant bits of the data currently stored in the memory loop (although this does assume the data on either side of the stored word contains no optical pulses).

Any time delays required to ensure that the data from the regenerative memory 100 is applied to the switching input 108 are achieved using suitable delay stages 103,104 between the output 15 of the switching element 13 and the regenerative memory 100 and between the output 102 of the regenerative memory 100 and the switching input 108 of the switching element 4.

It will be realised that the data stored in the regenerative memory 100 could be written into the memory loop by application to a switching input of the switching element 3.

A further alternative is for the data that has been read out of the memory loop and via the switching element 13 and stored in the regenerative memory 100 could be reapplied to the memory loop by coupling the output 102 to a second input (not shown) of the switching element 13. Accordingly, when a switching pulse is applied to the switching input 17 data pulses within the memory loop will be transferred from the input 18 to the output 15 removing data from the memory loop, whilst the data stored in the subsequent regenerative memory 100 is applied to the second input (not shown) of the switching element 13 and transferred directly to the memory loop. This allows the memory loop contents to be cleaned as data is written in.

Finally, it is also possible for the data to be read out of the memory loop and then simply written back into the memory loop at a subsequent time by replacing the subsequent regenerative memory 100 and the associated delay lines 103,104 by a single delay line. This single delay line could be used to introduce the required time delay before the data pattern is written back into the memory loop via one of the switching elements 3,4,12, as described above.

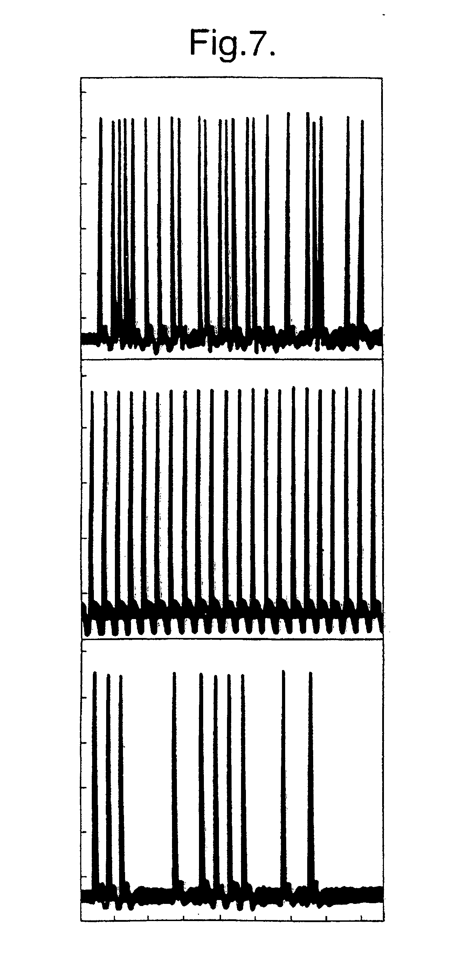

Figures 7, 8 and 9 show experimental results from writing and reading data from the memory with different "read" patterns. Each upper oscilloscope trace shows the 40 bit data sequence stored originally in the memory by inputting the "write" data only once. The middle oscilloscope traces show a section of the different data sequences used for the "read" operation, which were again input only once. Since there was only synchronisation of the stored data with the "read" data sequence at the bit level but no absolute synchronisation at the "memory frame" level, the length of the "read" data sequence was arranged to occupy the whole of the memory frame (∼1000 bits). This guaranteed that the 40 bits of stored data were read with the first occurrence of the "read" data. The lower oscilloscope trace shows the final stored data after pulses have been selectively read. Each Figure is arranged vertically in bit-level synchronisation, so that the occurrence of a "read" pulse leads to the removal of the corresponding originally stored pulse. From careful inspection, it can be seen that the three different final stored data patterns all correctly follow from the "read" data being applied.

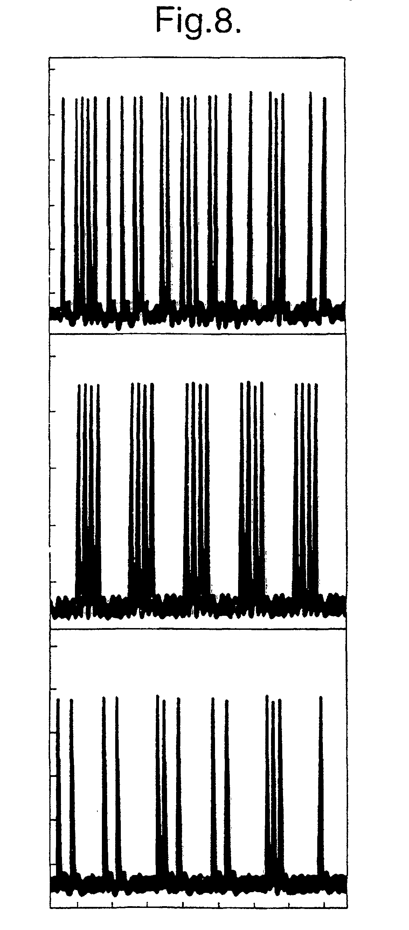

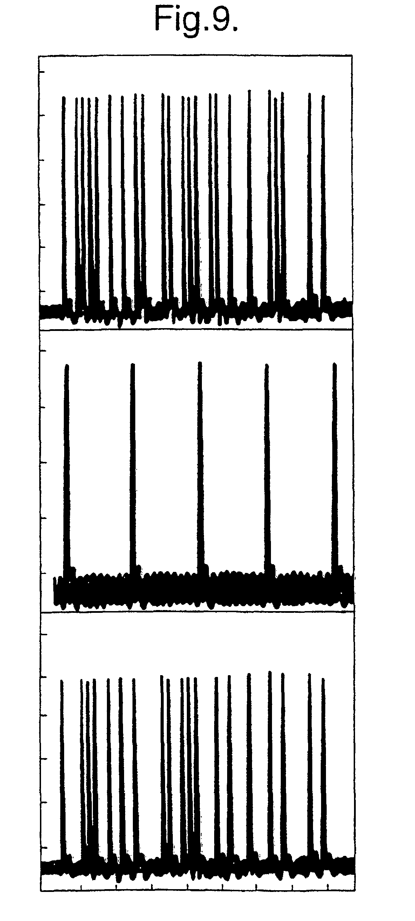

The read patterns used in Figures 7 to 9 were:
10101010101... - Figure 7
1111000011110000... - Figure 8
100000000010000000001... - Figure 9

As in the previous example, the erbium amplifier 12 has an adjustable gain so that the threshold level can be varied to achieve amplitude equalisation. In Figure 6, however, a number of additional erbium amplifiers 22 are also provided to ensure that the switching pulses have the correct energy.

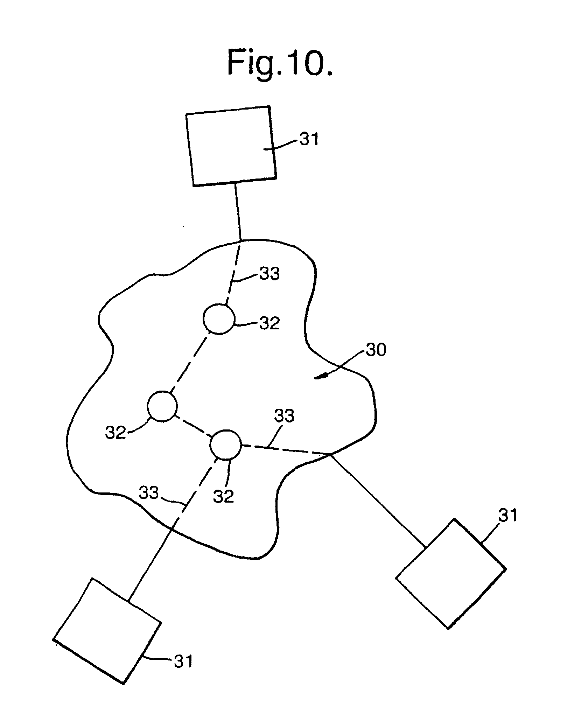

Figure 10 shows a communications network 30 having a number of end stations 31 connected across the network 30 via a number of network elements 32 and optical fibre communication links 33. The network endstations 31 each include a computer incorporating a regenerative optical memory in accordance with the present invention for storing data. Likewise, the network elements 32, which, for example, may be optical switches or optical repeaters, also include a regenerative optical memory in accordance with the present invention to enable optical data to be transmitted across the network 30.

## Claims

1. A regenerative optical memory comprising an optical loop (11) for circulating optical data pulses therein, and at least one non linear switching element (3,4) arranged along the loop (11), **characterised in that** an optical amplifier (12) is provided along the loop (11), the linear switching element(s) (3,4) and the amplifier (12) being arranged so as to regenerate the optical pulses circulating in the loop (11), the optical amplifier (12) having a gain such that only pulses with an amplitude above a threshold value are stored in the memory and the amplitude of optical pulses stored in the memory is substantially equalised to at least one predetermined level after a number of circulations within the optical loop (11).

2. A regenerative optical memory, as claimed in Claim 1, wherein at least one non linear switching elements (3,4) has a sinusoidal transmission function.

3. A regenerative optical memory as claimed in Claim 1 or Claim 2, wherein two non linear switching elements (3,4) are provided along the loop (11) such that they are concatenated, the two non linear switching (3,4) elements being coupled together by an optical storage element (11).

4. A regenerative optical memory as claimed in Claim 3, wherein the optical storage element is a length of optic fibre.

5. A regenerative optical memory according to any of the preceding claims, wherein means are provided to vary the threshold value at which the pulses are stored.

6. A regenerative optical memory according to any of the preceding claims, wherein means are provided for changing the spectral energy of the optical data pulses.

7. A regenerative optical memory according to any of the preceding claims, wherein the or each optical switching element is an interferometric non-linear switch (3,4) having an associated optical amplifier as the non-linear element.

8. A regenerative optical memory according to any of the preceding claims, comprising a further optical switching element (13) within the optical loop (11) for selectively switching at least a portion of the data pulses out of the optical loop (11) in response to the application of an optical signal from an optical source (2) to an input (17) of the further optical switching element (13) in order to alter the contents of the memory.

9. A regenerative optical memory according to Claim 8, wherein at least the further optical switching element (13) is a terahertz optical asymmetric demultiplexer, which is responsive to switching pulses from the optical source to allow data to be switched out of the optical loop.

10. A regenerative optical memory system comprising a first regenerative memory as claimed in Claim 8 or Claim 9, and a second regenerative optical memory (100), the further optical switching element output (15) of the first memory being connected to an input (101) of the second optical memory for storing at least a portion of a data pattern read out from the first optical memory.

11. A regenerative optical memory system according to claim 10, wherein the second optical memory (100) includes an output (102) coupled to an input (108) of the first optical memory for reading data from the second optical memory (100) to the first optical memory.

12. A regenerative optical memory system according Claim 11, where the input (108) of the first optical memory is a second input of the optical switching element, and wherein the output (102) of the second regenerative memory (100) is coupled to the second input of the optical switching element such that at least a portion of the data pattern in the second optical memory (100) may be read into the first optical memory in response to the application of an optical signal to the input of the optical switching element.

13. A computer comprising an optical memory according to any of the preceding claims.

14. An optical repeater comprising an optical memory according to any of Claims 1 to 13.

15. A communication network comprising an optical memory according to any of Claims 1 to 13.

## Patentansprüche

1. Regenerativer optischer Speicher, der eine optische Schleife (11), in der optische Datenimpulse umlaufen, und wenigstens ein nichtlineares Schaltelement (3, 4), das längs der Schleife (11) angeordnet ist, umfaßt, **dadurch gekennzeichnet, daß** längs der Schleife (11) ein optischer Verstärker (12) vorgesehen ist, wobei das (die) nichtlineare(n) Schaltelement(e) (3, 4) und der Verstärker so beschaffen sind, daß sie die in der Schleife (11) umlaufenden optischen Impulse regenerieren, wobei der optische Verstärker (12) einen Verstärkungsfaktor besitzt, derart, daß nur Impulse mit einer Amplitude oberhalb eines Schwellenwertes in dem Speicher gespeichert werden und die Amplitude optischer Impulse, die in dem Speicher gespeichert sind, nach einer Anzahl von Umläufen in der optischen Schleife (11) im wesentlichen an wenigstens einen vorgegebenen Pegel angeglichen wird.

2. Regenerativer optischer Speicher nach Anspruch 1, bei dem wenigstens ein nichtlineares Schaltelement (3, 4) eine sinusförmige Übertragungsfunktion besitzt.

3. Regenerativer optischer Speicher nach Anspruch 1 oder Anspruch 2, bei dem längs der Schleife (11) zwei nichtlineare Schaltelemente (3, 4) vorgesehen sind, derart, daß sie verkettet sind, wobei die zwei nichtlinearen Schaltelemente (3, 4) über ein optisches Speicherelement (11) miteinander gekoppelt sind.

4. Regenerativer optischer Speicher nach Anspruch 3, bei dem das optische Speicherelement ein Teilstück einer Lichtleitfaser ist.

5. Regenerativer optischer Speicher nach einem der vorhergehenden Ansprüche, bei dem Mittel vorgesehen sind, die den Schwellenwert, bei dem die Impulse gespeichert werden, variieren.

6. Regenerativer optischer Speicher nach einem der vorhergehenden Ansprüche, bei dem Mittel vorgesehen sind, die die Spektralenergie der optischen Datenimpulse ändern.

7. Regenerativer optischer Speicher nach einem der vorhergehenden Ansprüche, bei dem das oder jedes optische Schaltelement ein interferometrischer, nichtlinearer Schalter (3, 4) ist, dem als das nichtlineare Element ein optischer Verstärker zugeordnet ist.

8. Regenerativer optischer Speicher nach einem der vorhergehenden Ansprüche, der ein weiteres optisches Schaltelement (13) in der optischen Schleife (11) aufweist, um in Reaktion auf die Eingabe eines optischen Signals von einer optischen Quelle (2) in einen Eingang (17) des weiteren optischen Schaltelements (13) wenigstens einen Teil der Datenimpulse wahlweise aus der optischen Schleife (11) auszukoppeln, um die Inhalte des Speichers zu ändern.

9. Regenerativer optischer Speicher nach Anspruch 8, bei dem wenigstens das weitere optische Schaltelement (13) ein optischer, asymmetrischer Terahertz-Demultiplexer ist, der auf Schaltimpulse von der optischen Quelle anspricht, um ein Auskoppeln von Daten aus der optischen Schleife zuzulassen.

10. Regeneratives optisches Speichersystem, das einen ersten regenerativen Speicher nach Anspruch 8 oder Anspruch 9 und einen zweiten regenerativen optischen Speicher (100) umfaßt, wobei der Ausgang (15) des weiteren optischen Schaltelements des ersten Speichers mit einem Eingang (101) des zweiten optischen Speichers verbunden ist, um wenigstens einen Teil eines aus dem ersten optischen Speicher ausgelesenen Datenmusters zu speichern.

11. Regeneratives optisches Speichersystem nach Anspruch 10, bei dem der zweite optische Speicher (100) einen mit einem Eingang (108) des ersten optischen Speichers gekoppelten Ausgang aufweist, um Daten aus dem zweiten optischen Speicher (100) in den ersten optischen Speicher einzulesen.

12. Regeneratives optisches Speichersystem nach Anspruch 11, bei dem der Eingang (108) des ersten optischen Speichers ein zweiter Eingang des optischen Schaltelements ist und bei dem der Ausgang (102) des zweiten regenerativen Speichers (100) mit dem zweiten Eingang des optischen Schaltelements gekoppelt ist, so daß wenigstens ein Abschnitt des Datenmusters in dem zweiten optischen Speicher (100) in Reaktion auf die Eingabe eines optischen Signals in den Eingang des optischen Schaltelements in den ersten optischen Speicher eingelesen werden kann.

13. Computer, der einen optischen Speicher nach einem der vorhergehenden Ansprüche umfaßt.

14. Optischer Verstärker, der einen optischen Speicher nach einem der Ansprüche 1 bis 13 umfaßt.

15. Kommunikationsnetz, das einen optischen Speicher nach einem der Ansprüche 1 bis 13 umfaßt.

## Revendications

1. Mémoire optique à régénération comprenant une boucle optique (11) destinée à faire circuler des impulsions de données optiques dans celle-ci, et au moins un élément de commutation non linéaire (3, 4) agencé le long de la bouclé (11), **caractérisée en ce qu'**un amplificateur optique (12) est prévu le long de la boucle (11), le ou les éléments de commutation non linéaires (3, 4) et l'amplificateur (12) étant agencés de façon à régénérer les impulsions optiques circulant dans la boucle (11), l'amplificateur optique (12) comportant un gain de sorte que seules les impulsions présentant une amplitude supérieure à une valeur de seuil sont mémorisées dans la mémoire et que l'amplitude des impulsions optiques mémorisées dans la mémoire est sensiblement rendue égale à au moins un niveau prédéterminé après un certain nombre de circulations à l'intérieur de la boucle optique (11).

2. Mémoire optique à régénération selon la revendication 1, dans laquelle au moins un élément de commutation non linéaire (3, 4) présente une fonction de transmission sinusoïdale.

3. Mémoire optique à régénération selon la revendication 1 ou la revendication 2, dans laquelle deux éléments de commutation non linéaires (3, 4) sont prévus le long de la boucle (11) de sorte qu'ils sont concaténés, les deux éléments de commutation non linéaires (3, 4) étant couplés ensemble par un élément de mémorisation optique (11).

4. Mémoire optique à régénération selon la revendication 3, dans laquelle l'élément de mémorisation optique est une longueur de fibre optique.

5. Mémoire optique à régénération selon l'une quelconque des revendications précédentes, dans laquelle des moyens sont prévus pour faire varier la valeur de seuil à laquelle les impulsions sont mémorisées.

6. Mémoire optique à régénération selon l'une quelconque des revendications précédentes, dans laquelle des moyens sont prévus en vue de modifier l'énergie spectrale des impulsions de données optiques.

7. Mémoire optique à régénération selon l'une quelconque des revendications précédentes, dans laquelle l'élément de commutation optique ou bien chaque élément de commutation optique est un commutateur non linéaire interférométrique (3, 4) comportant un amplificateur optique associé en tant qu'élément non linéaire.

8. Mémoire optique à régénération selon l'une quelconque des revendications précédentes, comprenant un autre élément de commutation optique (13) à l'intérieur de la boucle optique (11) destiné à commuter de façon sélective au moins une partie des impulsions de données hors de la boucle optique (11) en réponse à l'application d'un signal optique depuis une source optique (2) vers une entrée (17) de l'autre élément de commutation optique (13) de manière à modifier le contenu de la mémoire.

9. Mémoire optique à régénération selon la revendication 8, dans laquelle au moins l'autre élément de commutation optique (13) est un démultiplexeur asymétrique optique dans le domaine des térahertz, qui est sensible à des impulsions de commutation provenant de la source optique afin de permettre que les données soient commutées hors de la boucle optique.

10. Système de mémoire optique à régénération comprenant une première mémoire à régénération selon la revendication 8 ou la revendication 9, et une seconde mémoire optique à régénération (100), l'autre sortie d'élément de commutation optique (15) de la première mémoire étant reliée à une entrée (101) de la seconde mémoire optique en vue de mémoriser au moins une partie d'un motif de données lu à partir de la première mémoire optique.

11. Système de mémoire optique à régénération selon la revendication 10, dans lequel la seconde mémoire optique (100) comprend une sortie (102) couplée à une entrée (108) de la première mémoire optique en vue de lire des données depuis la seconde mémoire optique (100) vers la première mémoire optique.

12. Système de mémoire optique à régénération selon la revendication 11, dans lequel l'entrée (108) de la première mémoire optique est une seconde entrée de l'élément de commutation optique, et où la sortie (102) de la seconde mémoire à régénération (100) est couplée à la seconde entrée de l'élément de commutation optique de sorte qu'au moins une partie du motif de données dans la seconde mémoire optique (100) peut être lu dans la première mémoire optique en réponse à l'application d'un signal optique à l'entrée de l'élément de commutation optique.

13. Ordinateur comprenant une mémoire optique selon l'une quelconque des revendications précédentes.

14. Répéteur optique comprenant une mémoire optique selon l'une quelconque des revendications 1 à 13.

15. Réseau de communication comprenant une mémoire optique selon l'une quelconque des revendications 1 à 13.
